Europäisches Patentamt

European Patent Office

Office européen des brevets

(11) Publication number : **0 468 656 A1**

(12) **EUROPEAN PATENT APPLICATION**

(21) Application number : **91306135.4**

(22) Date of filing : **05.07.91**

(51) Int. Cl.$^5$ : **H03M 7/40, H03M 5/12**

(30) Priority : **06.07.90 JP 179319/90**

(43) Date of publication of application :
**29.01.92 Bulletin 92/05**

(84) Designated Contracting States :
**DE FR GB**

(71) Applicant : **KABUSHIKI KAISHA TOSHIBA**
**72, Horikawa-Cho Saiwai-ku**
**Kawasaki-shi Kanagawa-ken (JP)**

(72) Inventor : **Sakazaki, Yoshihisa, c/o Intellectual**
**Property Div**
**Toshiba Corporation, 1-1-1 Shibaura**
**Minato-ku, Tokyo (JP)**

(74) Representative : **Muir, Ian R. et al**
**HASELTINE LAKE & CO. Hazlitt House 28**
**Southampton Buildings Chancery Lane**
**London WC2A 1AT (GB)**

(54) **Digital signal modulator.**

(57) A digital signal modulator modulates an input digital data code to a channel code which has more bits than that of the input data code. The digital signal modulator comprises an NRZI transformer and a modulator. The NRZI transformer NRZI-transforms an input channel code and the modulator then modulates the input data code into a channel code. The modulation is implemented by selection of a channel code so that the DSV converges to zero from two channel codes assigned in advance to each of input data codes. The above two channel codes have different polarities of CDS values after the NRZI transform. The channel code is defined so that the number of '1's in the channel code is odd if a value of the CDS equals zero after the NRZI transform.

EP 0 468 656 A1

FIG. 4

The present invention generally relates to digital signal modulators and, more particularly, to digital signal modulators where low frequency components of the modulated signal are suppressed, and to a method of digital signal modulation adapted, for example, for a video cassette recorder which records a signal on a tape through a rotary transformer.

Generally, it is difficult for a video cassette recorder (VCR) which records a signal on a tape through a rotary transformer to transmit low frequency components of signal. Thus, a modulation system should preferably not have a low frequency power spectrum, i.e., a so-called D.C.-free modulation system is desired.

Many kinds of modulation systems which use D.C.-free modulation and high density recording have been proposed. For example, there is a code modulation system called 8-14 modulation where data is modulated to a 14 bit code for every 8 bits of data. The code assignment in 8-14 modulation is in a 1:1 correspondence with a data to modulation code whose CDS value (to be described later) is '0'. The code assigned in a 8-14 modulation is in a 1:2 correspondence with a data to modulation code whose CDS value is not '0'. That is, data corresponds with two modulation codes by separating into two groups which have positive and negative CDS values (i.e., a modulation code whose CDS value is not '0').

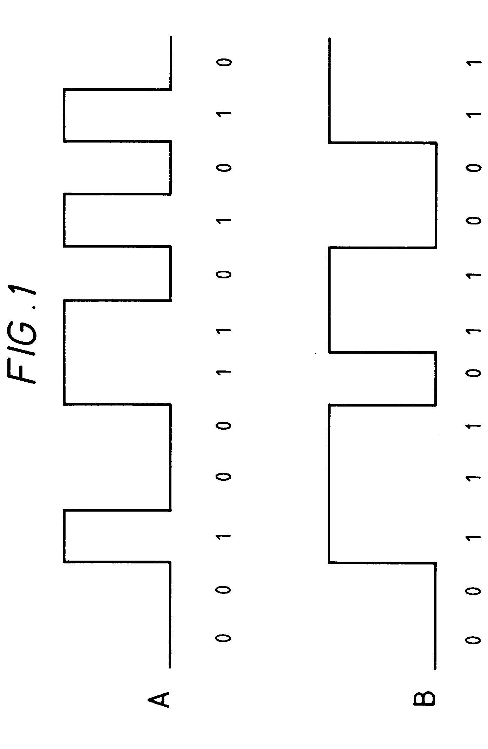

CDS is an abbreviation for Codeword Digital Sum, and is the DSV value (described below) from the first bit to last bit of a codeword. DSV is an abbreviation for Digital Sum Variation, and is the integrated value of a recorded waveform after a modulation is NRZI-transformed, NRZI transformation is described below in conjunction with Figure 1. Figure 1(A) illustrates an input digital signal. NRZI transformation (sometimes called "change on ones" transformation) is a transform where output polarity (Figure 1(B)) is changed every time a "1" appears in the input signal. If the waveform is at a high level after the NRZI transform a '1'(positive polarity) is set and if the waveform is at a low level after the NRZI transform, a '-1'(negative polarity) is set. In either instance the waveform after the NRZI transform starts from a low level. If the DSV value ever becomes infinitely large, the code has a direct current component. If the deviation of the DSV value is limited, the code is called D.C. free. A "D.C. free" modulation code is defined as a code where the absolute value of the DSV is always within a limited value range and does not diverge. Thus, in code modulation, the last DSV value and polarity of the waveform need to be monitored. The code is selected from an adequate group so that the range of the DSV is limited. For Example, on a code whose CDS is not '0', the code selection is implemented under the rule shown in Table 1.

## TABLE 1

| DSV | Polarity of Waveform | Selected Modulation Code |
|---|---|---|
| positive | positive | positive CDS |
| positive | negative | negative CDS |
| zero | positive | smaller absolute value of CDS |
| zero | negative | smaller absolute value of CDS |
| negative | positive | negative CDS |
| negative | negative | positive CDS |

According to Table 1, in a case where codes with CDS value of "0" appear continuously after a code transformation of a channel was completed where the DSV was, for example, '+4', the DSV will stay at '+4' for a long time.

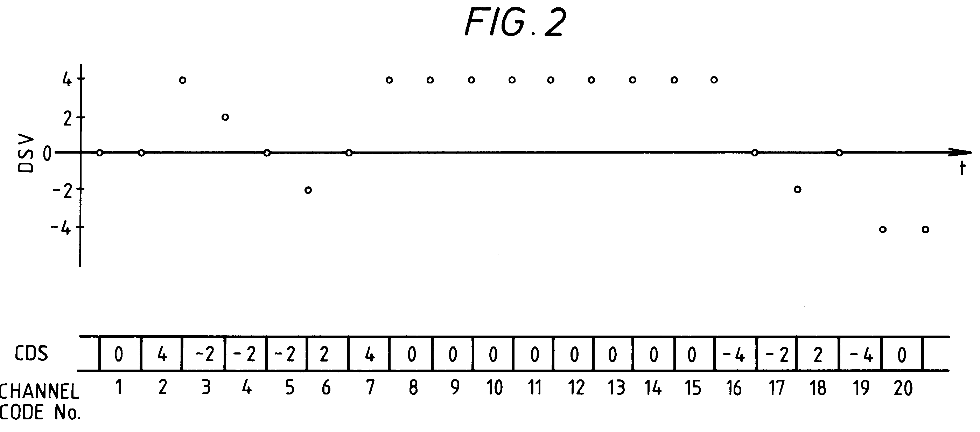

Figure 2 illustrates a DSV characteristic showing the above phenomenon. At channel code No. 7, for example, the DSV is at '+4'. After that, at channel codes No. 8 through No. 15, the DSV stays at '+4' as the CDS values for these positions are all '0'. If the DSV stays at a constant value for a long time as mentioned above, these portions will become a low frequency component in the modulated signal. As mentioned above, in a magnetic recording apparatus, especially a transmission system which uses a rotary transformer such as a VCR, it is difficult to record and reproduce the low frequency components of a signal. It is thus undesirable for a modulation signal to include a low frequency component.

One prior countermeasure to the phenomenon of continuous deviation of the DSV is to set the DSV coordinator just before a synchronous signal and then setting the DSV to '0' every synchronous signal block. A DSV coordinator is comprised of a group of signals which set the DSV to "0" just before the synchronous signal. However, such synchronous signal blocks are generally large, approximately 1000 bits. Even if the deviation of the DSV is modified for every period of such a synchronous signal, there is still an extremely low frequency signal component left. Setting many DSV coordinators increases redundancy and reduces the transmission efficiency of data.

Accordingly, the present invention seeks to provide an improved digital signal modulator where the DSV does not stay at a large absolute value, and the signal modulation does not include any low frequency components.

The present invention seeks to provide an improved method of digital signal modulation. In accordance with the present invention, a digital signal modulator modulates an input digital data code to a channel code which has more bits than that of the input data code and comprises a NRZI transformer and a modulator. The NRZI transformer NRZI-transforms an input channel code. The modulation is implemented by selecting a channel code so that the DSV converges to zero from two channel codes assigned in advance to each of the input data codes. The two channel codes have different CDS polarities after the NRZI transform. The channel code is thus defined so that the number of '1's in the channel code is odd if the value of CDS equals zero after the NRZI transform.

Other objects, features, and advantages of the present invention will become apparent from the following detailed description. It should be understood, however, that the detailed description and specific examples, while indicating preferred embodiments of the invention, are given by way of illustration only, since various changes and modifications within the spirit and scope of the invention will become apparent to those skilled in the art from this detailed description.

For a better understanding of the present invention and to show how it may be brought into effect, reference will now be made, by way of example to the following drawings, in which:

Figures 1(A) and 1(B) illustrate input and output characteristics in an NRZI transformation.

Figure 2 illustrates deviation of the DSV according to the prior art.

Figure 3 illustrates an example of a transition of the DSV according to the present invention.

Figure 4 is a block diagram of the digital signal modulation circuit according to the present invention.

The preferred embodiment of the present invention will now be described in more detail with reference to the accompanying drawings.

In the preferred embodiment, modulation is a an 8-14 modulation where the 8-bit input data is modulated to a 14-bit modulation code. The modulation codes are divided by the CDS value into bit patteerns satisfying the following three conditions:

(1) The bit pattern has no pattern where a logic '1' continues successively.

(2) The bit pattern has a top bit of '0'.

(3) The bit pattern having a logic number '1' is odd if the CDS is '0'.

Table 2 shows the number of the modulation codes according to each CDS value under the above conditions.

## TABLE 2

| Value of CDS | Total | |
|---|---|---|
| 8 | 12 | A group |
| 6 | 27 | (where the value of |
| 4 | 59 | the CDS is zero or more) |
| 2 | 96 | (total 257) |
| 0 | 63 | |
| -2 | 117 | B group |
| -4 | 87 | (where the value of |
| -6 | 54 | the CDS is less than zero) |
| | | (total 258) |

There are 257 codes where polarity of the CDS is zero or positive and 258 codes where polarity of the CDS is negative. These codes correspond to a 256 input 8-bit data code with a correspondence of 1:2. That is, a 1:2 relationship is made by selecting a code from the A and B groups, respectively, on each of the 256 data codes. An important point is selecting the modulation code where the number of logic '1' is odd. Additionally, in the preferred embodiment, the waveform after the NRZI transform should start from a low level. After the relationship between the data code and channel code is determined by above method, then one channel code is selected from two channel codes according to Table 3 described below. The DSV value of the modulation code is controlled so as to converge to zero.

## TABLE 3

| DSV | polarity of wave form just before the code | code group to be selected |
|---|---|---|
| positive | positive | A |
| | negative | B |
| zero | positive | code group having smaller absolute value of CDS |
| | negative | |
| negative | positive | B |
| | negative | A |

If the code selection is made according to Table 3, a code is selected so that the DSV approaches zero (i.e., converges). If a code with a CDS of zero is selected, the polarity of waveform inverts after the NRZI transform without a change in the DSV as the code has odd number of '1's. Thus, if the DSV is not zero, a code of the B group (where the CDS is not zero) is selected at the next code selection, and a code with a CDS of zero is not selected.

The above description is entered into more detail below. For example, suppose a channel code is NRZI-modulated. In this case the waveform is defined by the CDS on the premise that waveform starts from a negative polarity. If the waveform has a positive polarity, the CDS value has the same absolute value before modulation as it does after the NRZI transform. However, the polarity of the CDS would change. For example, if the rules of Table 3 are adapted, and the DSV just before a code is positive, and if polarity of waveform is positive, one of the A group of channel codes (where the CDS is equal to or greater than zero) would be selected. In such a case, if the polarity of waveform is positive and the CDS of the channel code is equal to or below zero after the WRZI transform, the DSV will decrease or stay at same value.

In another example, the code whose CDS equals zero is selected. If the DSV is positive, the polarity of the waveform is also positive and one of the A group of codes is selected where the CDS equals zero. The polarity of waveform would become positive after the NRZI transform of the channel code. This is because a code where the CDS equals zero has an odd number of '1's. That is, according to the rule under which polarity reverses when a '1' appears, the number of changes in polarity is odd. Thus, the polarity of the waveform is reversed after the code is modulated. In this case, the CDS equal zero, the DSV does not change. In the next code selection, one of the B group of codes where the CDS is not zero would always be selected.

If the DSV is positive, a code where the CDS would equal zero would not be selected continuously for similar reasons. If the DSV equal zero, there is no problem in that there is no deviation in the DSV even if a code were adopted where the CDS equal zero.

Next, the maximum period of a DSV value is examined. To shorten the period of the DSV, the amplitude of the DSV needs to be small, preferably near zero. This is because the DSV can have, for example, a positive value if the amplitude of the DSV is great.

According to the rule of Table 3, a channel code where the absolute value of the CDS is smaller than the other of a pair of channel codes which is prepared to each input data code as mentioned above, is selected when the DSV equals zero. Thus, it is important to make at least one channel code of a pair of channel codes to a data code as small as possible. Pairs of the A and B groups of codes are shown below in Table 4 from total modulation codes shown in Table 2:

## TABLE 4

| A group | B group | Number |
|---|---|---|
| CW1  ( 0, | -6 ) | 52 |
| CW2  ( 0, | -4 ) | 11 |
| CW3  ( 2, | -4 ) | 76 |
| CW4  ( 2, | -2 ) | 20 |
| CW5  ( 4, | -2 ) | 59 |
| CW6  ( 6, | -2 ) | 27 |
| CW7  ( 8, | -2 ) | 11 |
| | | Total: 256 |

Where each numeral in parenthesis in Table 4 is the CDS.

The time when the DSV becomes largest is when a modulation code is selected such that the DSV becomes $\pm 6$ when the DSV equals $\pm 2$, and a code where the CDS equals 8 is selected. This is the maximum DSV value after the code modulation on a data code.

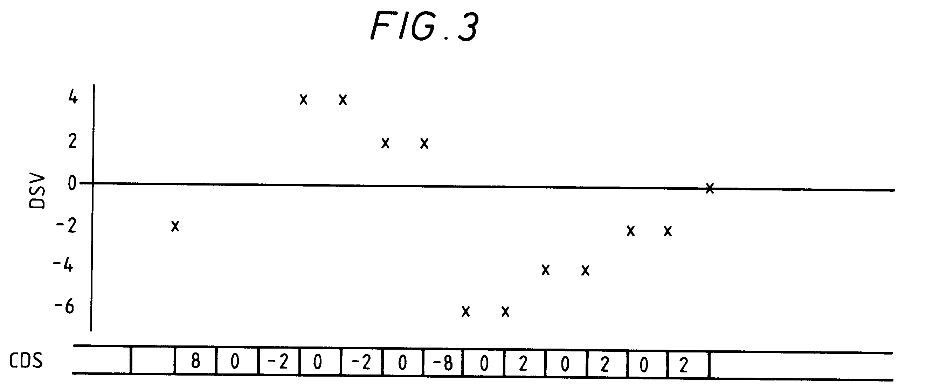

Figure 3 shows an example of a transition pattern which produces the lowest frequency component. The code where the CDS value is zero is selected when the maximum DSV value equals ±6. The DSV does not change, however, if the polarity of waveform is reversed because the code where the CDS equals zero has odd number of '1's. Thus, one of the B group of codes (in this example, where the CDS equals -2) is selected at the next code selection and one of the A group of codes (in this example, where the CDS equals zero) is selected. That is, the code where the CDS equals -8 is selected when the DSV equals 2.

Additionally , there exits in each DSV a reverse in polarity of the polarity of the DSV shown in Figure 2. In this case, the period of the DSV is equal to 13 codes or 182 bits (13 words x 14 bits). That is, the frequency of the low frequency components in the modulation signal generated at a period of change of the above DSV is 1/182nd of the bit frequency in a worst case (that is, at the maximum period or lowest frequency).

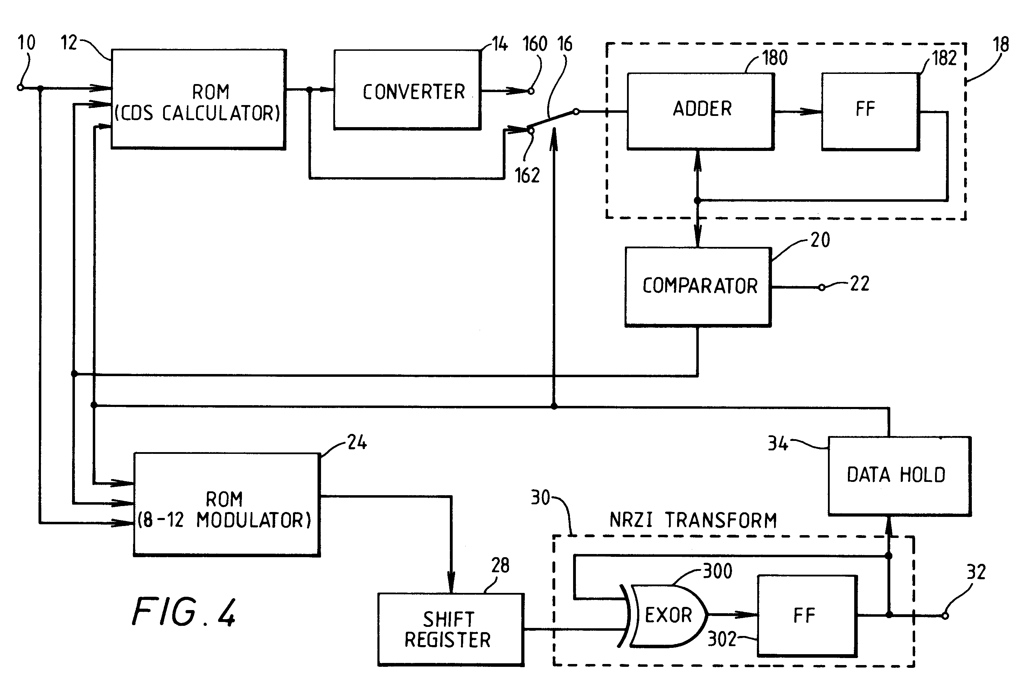

Figure 4 depicts one embodiment of the 8-14 modulation circuit of the present invention. Input terminal 10 receives an 8 bit data code. ROM (read only memory) 12, comprising a CDS calculator, is connected to input terminal 10. Converter 14 is connected to ROM 12, and converts polarity of the 4 bit signal from ROM 12. Input terminal 160 and 162 of switch 16 are connected to converter 14 and ROM 12. DSV calculator 18 is connected to the output terminal of switch 16. DSV calculator 18 includes adder 180 and flip flop 182. In particular, adder 180 is connected to switch 16, and adds the output of switch 16 and flip flop 182. Flip flop 182 is connected to adder 180 and outputs the calculated DSV value. Comparator 20 is connected to DSV calculator 18, and compares the output signal of DSV calculator 18 with a '0' input from input terminal 22.

ROM 24 connected to input terminal 10 and comparator 20, and comprises an 8-14 modulation circuit. ROM 24 converts input 8 bit parallel data code to 14-bit parallel channel code under the rule shown in Table 3 by using polarity of the DSV from comparator 20 and polarity of the waveform after the NRZI transform from data hold circuit 26. Shift register 28 is connected to ROM 24, and comprises a parallel to serial converter. That is, shift register 28 converts the 14 bit parallel channel code to a 14 bit serial channel code by reading out each bit one by one at a speed 14 times that of the input data.

NRZI transform circuit 30 is connected to shift register 28, and comprises EXOR (exclusive OR) circuit 300 and flip flop 302. NRZI transform circuit 30 NRZI-transforms the serial channel data from shift register 28. An output terminal 32 is connected to NRZI transform circuit 30 (more precisely, to flip flop 302). A data hold circuit 34 is connected to NRZI transform circuit 30, and holds the last polarity of the waveform by holding data (low and high level data) for the same time as the period of the transforming 14 bit data. Data hold circuit 34 switches the connection of switch 16 and code modulation of ROM 24 by using a 1-bit polarity data.

The embodiment of Figure 4 operates as follows. The 8-bit parallel data code input from input terminal 10 is converted to a 14-bit parallel channel code in ROM 24 by using the DSV polarity from comparator 20 and the waveform polarity after the NRZI transform from data hold circuit 31 according to the selection rule of modulation code in Table 3. The waveform polarity is the last polarity of the prior channel code which has been NRZI-transformed. The 14-bit parallel channel code from ROM 24 is converted into 14-bit serial data in parallel-serial converter 28 and subsequently NRZI-transformed in NRZI transform circuit 30. Finally, recording waveform signal is output from output terminal 32.

Additionally, the CDSs of the channel codes output from ROM 24 are also output from ROM 12. That is because the same input data to ROM 24 is input to ROM 12, and each the CDS of channel codes is also stored in ROM 12. If polarity of waveform after the NRZI transform on a former channel cide is positive, the calculation of the new DSV in the DSV calculation circuit 18 needs to be implemented by adding the polarity-inverted CDS value, output from ROM 12, of the new channel code to form the DSV. This is because the CDS value of a channel code is calculated on the supposition that the polarity of waveform always starts from a negative polarity. Thus, output from data hold circuit 34 (polarity data) is used in switching of switch 16. If the polarity data is positive, switch 16 is switched to terminal 160 so that the CDS value whose polarity is reversed is supplied to the DSV calculation circuit 18.

The polarity (positive, negative or zero) of the DSV calculated as mentioned above is detected by comparator 20.

Modifications and variations of the present invention are possible in light of the above teachings. It is therefore to be understood that, within the scope of the appended claims, the present invention can be practiced in a manner other than as specifically described herein.

## Claims

1.  A digital signal modulator for modulating an input digital data code to a channel code which has more bits than that of the input data code, comprising an NRZI transformer (30) for NRZI transforming an input channel code, and a modulator (24) for modulating an input digital data code to a channel code, characterised in that the digital signal modulator further comprises a codeword digital sum calculator (12) for calculating the codeword digital sum value of the input data code, a digital sum variation calculator (18) for calculating the digital sum variation by using the codeword digital sum calculated by said codeword digital sum calculator (12); and

modulation of the modulator is implemented by selection of a channel code so that digital sum variation converges to zero from two channel codes assigned in advance to each of the input data codes, and wherein the two channel codes have codeword digital sums of different polarites after the NRZI transform and the channel code is defined so that the number of '1' in the channel code is odd if the value of codeword digital sum equals zero after the NRZI transform.

2. A digital signal modulator as claimed in claim 1, further comprising a parallel-serial converter (28) connected between said modulator (24) and said NRZI transformer (30) for converting a serial channel code to a parallel channel code.

3. A digital signal modulator as claimed in claim 2, wherein said parallel-serial transformer (28) includes a shift register.

4. A digital signal modulator as claimed in one of claims 1 to 3, wherein said NRZI transformer (30) comprises an EXOR circuit (300) and a flip flop circuit (302) connected in series.

5. A digital signal modulator as claimed in any preceding claim, wherein said codeword digital sum calculator (12) comprises a ROM.

6. A digital signal modulator as claimed in any preceding claim, wherein-said digital sum variation calculator (18) comprises an adder (180) and a flip flop (182) connected in series.

7. A digital signal modulator as claimed in any preceding claim, further comprising a data holding circuit (34) for holding NRZI-transform data for the same time as modulation time in modulator.

8. A digital signal modulator as claimed in any preceding claim, further comprising a converter (14) connected between said codeword digital sum calculator (12) and said digital sum variation calculator (18) for converting polarity of the codeword digital sum value according to the output of said data holding circuit (34).

9. A digital signal modulator as claimed in any preceding claim, wherein said modulator (24) comprises a ROM.

10. A digital signal modulator as claimed in any preceding claim, wherein said modulator (24) modulates 8-bit input data to 14-bit channel data.

11. A method of modulating a digital signal, wherein an input digital data code is modulated to a channel code which has more bits than that of the input data code, comprising the steps of:

NRZI-transforming the channel code;

assigning two channel codes to each of all input data codes, where the two channel codes have different polarity codeword digital sum values after the NRZI transform, and the channel code is defined so that the number of '1's in the channel code is odd if a codeword digital sum value equals zero after the NRZI transform; and

selecting a channel code from two channel codes assigned to each of all input data codes so that the digital sum variation converges to zero.

12. A method of modulating a digital signal as claimed in claim 11, wherein the selecting step includes a step of selecting a channel code which has the smaller absolute codeword digital sum value from the two channel codes if the digital sum variation just before the channel is zero after the NRZI transform.

13. A method of modulating a digital signal as claimed in claim 11, wherein the selecting step includes a step of selecting a channel code whose digital sum variation has a different polarity from that of the digital sum variation just before the channel code if the digital sum variation just before the channel code is not zero.

14. A method of modulating a digital signal as claimed in claim 11, wherein the selecting step includes a step of selecting a channel code so that the absolute value of the digital sum variation becomes smaller if the digital sum variation just before the channel code is not zero.

15. A digital signal modulator for modulating an input digital data code to a channel code which has more bits than that of the input data code comprising NRZI transformer (30) for NRZI transforming an input channel code, characterised in that the digital signal modulator further comprises channel code data store means (24) for storing two channel codes assigned in advance to each of the input data codes wherein the two channel codes have different polarities their codeword digital sum values after an NRZI transform, and the channel code is defined so that the number of '1's in the channel code is odd if the codeword digital sum value equals zero after an NRZI transform, and channel code data selection means (12,14,16,18,20,34) for selecting a channel code from two channel codes assigned to the input data code so that the digital sum variation converges to zero.

16. A digital signal modulator as claimed in claim 15, wherein said channel code data selection means (12,14,16,18,20,34) includes a controller for selecting a channel code which has a smaller absolute value of the codeword digital sum from the two channel codes if the digital sum variation just before the channel code is zero after an NRZI transform.

17. A digital signal modulator as claimed in claim 15, wherein the channel code data section means (12,14,16,18,20,34) includes a controller for selecting a channel code whose the digital sum variation has different polarity from that of the digital sum variation just before the channel code if the digital sum variation just before the channel code is not zero.

18. A digital signal modulator as claimed in claim 15, wherein the channel code data selection means (12,14,16,18,20,34) comprises a codeword signal sum calculator (12) for calculating the codeword digital sum of the input data code and a digital sum variation calculator (18) for calculating the digital sum variation by using the codeword digital sum calculated by the codeword digital sum calculator (12).

# FIG .1

A

0   0   1   0   0   1   1   0   1   0   1   0

B

0   0   1   1   1   0   1   1   0   0   1   1

# FIG.2

EP 0 468 656 A1

| CDS | 0 | 4 | -2 | -2 | -2 | 2 | 4 | 0 | 0 | 0 | 0 | 0 | 0 | 0 | 0 | -4 | -2 | 2 | -4 | 0 | |
|-----|---|---|----|----|----|---|---|---|---|---|---|---|---|---|---|----|----|---|----|---|--|
| CHANNEL CODE No. | 1 | 2 | 3 | 4 | 5 | 6 | 7 | 8 | 9 | 10 | 11 | 12 | 13 | 14 | 15 | 16 | 17 | 18 | 19 | 20 | |

EP 0 468 656 A1

# FIG.3

DSV

4
2
0
-2
-4
-6

CDS

| | 8 | 0 | -2 | 0 | -2 | 0 | -8 | 0 | 2 | 0 | 2 | 0 | 2 | |

FIG. 4

EP 0 468 656 A1

European Patent
Office

**EUROPEAN SEARCH REPORT**

Application Number

| | DOCUMENTS CONSIDERED TO BE RELEVANT | | EP 91306135.4 |
|---|---|---|---|

| Category | Citation of document with indication, where appropriate, of relevant passages | Relevant to claim | CLASSIFICATION OF THE APPLICATION (Int. Cl.5) |
|---|---|---|---|
| A | US - A - 4 728 929<br>(TAWAKA)<br>* Totality *<br>---- | 1,11,<br>15 | H 03 M 7/40<br>H 03 M 5/12 |
| | | | |
| | | | **TECHNICAL FIELDS SEARCHED (Int. Cl.5)** |
| | | | H 03 M 7/00<br>H 03 M 5/00 |

The present search report has been drawn up for all claims

| Place of search | Date of completion of the search | Examiner |
|---|---|---|
| VIENNA | 22-10-1991 | BAUMANN |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
    .................................................
& : member of the same patent family, corresponding
    document

EPO FORM 1503 03.82 (P0401)